# EUROPEAN PATENT APPLICATION

(11) **EP 1 142 953 A1**
(43) Date of publication of application: **10.10.2001**
(21) Application number: 99961325.0
(22) Date of filing: 22.12.1999
(51) Int. Cl.: C08L 63/04, C08L 79/04, C08J 5/24, B32B 15/08

(54) **CYANATE-EPOXY RESIN COMPOSITION, AND PREPREG, METAL FOIL-LAMINATED PLATE AND PRINTED WIRING BOARD USING THE SAME**

(30) Priority: 24.12.1998 JP 36594798; 24.12.1998 JP 36594898
(71) Applicant: Hitachi Chemical Company, Ltd., Tokyo 163-0449 (JP)
(72) Inventor: TOMIOKA, Kenichi, Shimodate-shi, Ibaraki 308-0854 (JP); TAKANO, Nozomu, Yuki-shi, Ibaraki 307-0001 (JP); FUKUDA, Tomio, Shimodate-shi, Ibaraki 308-0001 (JP); MIYATAKE, Masato, Shimodate-shi, Ibaraki 308-0854 (JP); MIZUNO, Yasuyuki, Shimodate-shi, Ibaraki 308-0854 (JP)
(74) Representative: Albrecht, Thomas, Dr.
(86) International application number: JP9907227
(87) International publication number: WO0039216

(57) **Abstract**

A cyanate-epoxy resin composition comprising (A) a cyanate type compound containing two or more cyanato groups in one molecule thereof, (B) an epoxy resin, and (C) a curing accelerator, wherein the epoxy resin is derived from a dicyclopentadiene-phenol polyaddition product having a dicyclopentadiene skeleton, and the curing accelerator comprises a combination of a compound having the function to accelerate the curing reaction of the above (A) and a compound having the function to accelerate the curing reaction of the above (B). This cyanate-epoxy resin composition is excellent in glass transition temperature, dielectric characteristics, heat resistance and low susceptibility to water, and can be effectively used for preparing a prepreg and for manufacturing a laminate, a metal foil-laminated plate and a printed wiring board using the prepreg.

## Description

### TECHNICAL FIELD

The present invention relates to a cyanate-epoxy resin composition comprising a cyanate compound and an epoxy resin, and prepregs, metal foil-laminated plates and printed wiring boards using such a composition.

### BACKGROUND ART

The recent years have seen rapid progress of high-degree communication and information systems with computers integrated into communication devices. Computers have been reduced in size in line with the advancing downsizing tendency in the art, and yet are required to have a performance comparable with the conventional large-sized machines. Also, efforts have been and are being made for size and weight reduction and higher performance of the rapidly prevailing information terminal devices such as, most typically, handy-phones and personal computers. The printed circuit boards used in such devices are no exception; attempts are being made for realizing higher density and smaller size while enhancing heat resistance and insulation reliability of the boards. Further, in order to accommodate speed-up of signal and its increased frequency, hunt is being made for a material with a low specific dielectric constant and a low dielectric dissipation factor. To comply with these requests, as means for improving heat resistance of the printed circuit boards using an epoxy resin composition, there have been practiced the methods such as curing a polyfunctional epoxy resin with a dicyandiamide or curing it with a polyfunctional phenol resin.

Also, the following proposals have been made for improving dielectric properties of the epoxy resin-made printed wiring boards which have excellent heat resistance. For example, it has been proposed to react an epoxy resin with poly-4-methyl-1-pentene disclosed in JP-A-60-135425, a phenol-added butadiene polymer disclosed in JP-A-61-126162, a terminal carboxy-modified polybutadiene disclosed in JP-A-62-187736 or a propargyl-etherified aromatic hydrocarbon disclosed in JP-A-4-13717. There are also known the methods in which: hollow particles are allowed to exist in the resin layer as disclosed in JP-A-57-83090; fluorine resin powder is blended as disclosed in JP-A-2-203594; aromatic polyamide fiber is used as base as disclosed in JP-A-3-84040; a glass-cloth based fluorine resin prepreg and a glass-cloth based epoxy resin prepreg are laminated as disclosed in JP-A-4-24986.

On the other hand, cyanate ester resins and bismaleimide-triazine (BT) resins have also been proposed as resin materials with high heat resistance and low dielectric characteristics other than the epoxy resin-based materials. These resins, however, have disadvantages of being high in water absorption and poor in adhesive force and heat resistance when moisture is absorbed. In order to eliminate these defects of the cyanate ester resins and BT resins, a method has been proposed in which these resins are used in combination with an epoxy resin such as a diglycidyl-etherified product of a phenolic novolak disclosed in JP-A-63-54419, a glycidyl-etherified product of bisphenol A disclosed in JP-A-3-84040 or a glycidyl-etherified product of a brominated phenolic novolak disclosed in JP-A-2-286723.

The method which comprises curing a polyfunctional epoxy resin with a dicyandiamide has the problem that the dicyandiamide-cured resin is elevated in hygroscopicity, making it difficult to satisfy reliability on or in the insulation material in particular. Also, the occurrence of metallic migration (galvanic corrosion) - a phenomenon of a metal composing wiring, circuit pattern or electrodes on or in the insulating material to migrate on or in the insulating material by dint of potential difference under a high humidity environment - is posing a serious problem. On the other hand, according to the method which comprises curing with a polyfunctional phenol resin, the cured product of the resin becomes rigid and tends to produce fine cracks in working such as through-hole drilling, and such fine cracks are considered to initiate metallic migration. It is thus impossible with this method to satisfy the request for high insulation reliability.

The methods in which an epoxy resin is reacted with a hydrocarbon-based polymer such as poly-4-methyl-1-pentene, a phenol-added butadiene polymer or a terminal carboxy-modified polybutadiene, as disclosed in JP-A-60-135425, 61-126162 and 62-187736, respectively, involve the problem that innate heat resistance of epoxy resins may be impaired although the dielectric constant is lowered.

The proposal to react an epoxy resin with a propargyl-etherified aromatic hydrocarbon in JP-A-4-13717 has the problem of high cost because of use of a specific resin although high heat resistance can be obtained.

The methods comprising introduction of hollow particles into the resin layer or blending a fluorine resin powder such as disclosed in JP-A-57-83090 and JP-A-2-203594, and the methods featuring use of aromatic polyamide fiber as base or lamination of glass-cloth based fluorine resin prepregs such as disclosed in JP-A-3-84040 and JP-A-4-24986 are defective in that the mechanical properties worsen as compared with the conventional glass cloth based epoxy resin laminates although the dielectric constant of the laminates is lowered.

According to the method in which an epoxy resin is mixed with a cyanate ester resin as disclosed in JP-A-3-84040, although adhesion is improved, there can be obtained no outstanding effect for the reduction of water absorption or the improvement of heat resistance in the moisture-absorbed state. The method proposing combined use of different epoxy resins such as disclosed in JP-A-63-54419 is disadvantageous in that water absorption increases and also no significant effect is produced for the improvement of workability although reduction of Tg can be suppressed to some extent and also heat resistance in the moisture-absorbed state and adhesion to metals are improved. In case of using a glycidyl-etherified product of a brominated phenolic novolak disclosed in JP-A-2-286723, the problem of deteriorated susceptibility to water remains unsolved although improvements are made on workability and heat resistance in the moisture-absorbed state, and flame retardancy is provided.

### DISCLOSURE OF INVENTION

The present invention has for its object to provide a cyanate-epoxy resin composition which is high in glass transition temperature and has excellent dielectric characteristics and low susceptibility to water without vitiating the innate properties such as heat resistance and adhesiveness of the resin, and the prepregs, metal foil-laminated plates and printed wiring boards using the said composition.

The present invention provides a cyanate-epoxy resin composition comprising (A) a cyanate type compound containing two or more cyanato groups in one molecule thereof, (B) an epoxy resin, and (C) a curing accelerator as main components, wherein the epoxy resin is derived from a dicyclopentadiene-phenol polyaddition product having a dicyclopentadiene skeleton represented by the following formula (1): 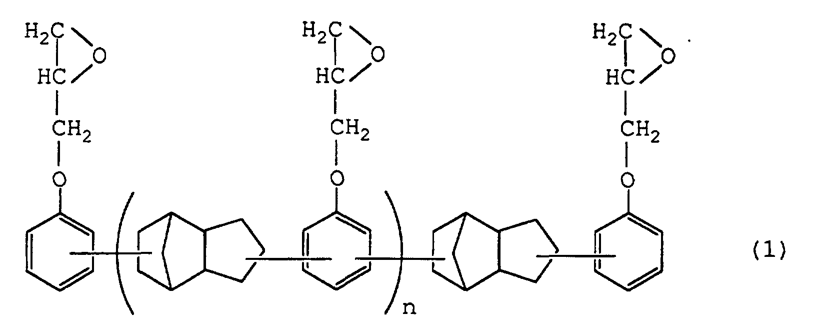 wherein n is 0 or a positive integer, and the curing accelerator comprises (i) a compound having a catalytic function to accelerate the curing reaction of the cyanate type compound containing two or more cyanato groups in one molecule, and (ii) a compound having a catalytic function to accelerate the curing reaction of the epoxy resin.

The present invention also provides a prepreg obtained by impregnating a base with said cyanate-epoxy resin composition and drying the same.

The present invention further provides a metal foil-laminated plate obtained by laminating a metal foil on one side or both sides of said prepreg or a laminate thereof and hot-press molding the same, and a printed wiring board obtained by forming circuits on the metal foil of the laminated plate.

### BEST MODE FOR CARRYING OUT THE INVENTION

The present invention, to be concrete, comprehends the following embodiments.
(1) A cyanate-epoxy resin composition comprising (A) a cyanate type compound containing two or more cyanato groups in one molecule thereof, (B) an epoxy resin, and (C) a curing accelerator as main components, wherein the epoxy resin is derived from a dicyclopentadiene-phenol polyaddition product having a dicyclopentadiene skeleton represented by the following formula (1): 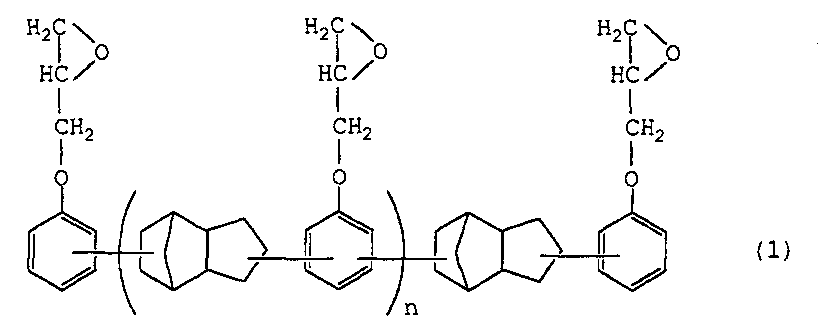 (wherein n is 0 or a positive integer), and the curing accelerator comprises (i) a compound having a catalytic function to accelerate the curing reaction of the cyanate type compound containing two or more cyanato groups in one molecule and (ii) a compound having a catalytic function to accelerate the curing reaction of the epoxy resin.
(2) A cyanate-epoxy resin composition set forth in (1) above, wherein the compound having a catalytic function to accelerate the curing reaction of the cyanate type compound containing two or more cyanato groups in one molecule is an organic metal salt or an organic metal complex, and the compound having a catalytic function to accelerate the curing reaction of the epoxy resin is an imidazole type compound.
(3) A cyanate-epoxy resin composition set forth in (2) above, wherein the organic metal salt or the organic metal complex is an organic metal salt or an organic metal complex of iron, copper, zinc, cobalt, nickel, manganese or tin.
(4) A cyanate-epoxy resin composition set forth in any one of (1) to (3) above, wherein the epoxy resin (B) is contained in an amount of 50 to 250 parts by weight and the curing accelerator (C) in an amount of 0.1 to 5 parts by weight per 100 parts by weight of the cyanate type compound containing two or more cyanato groups in one molecule.
(5) A cyanate-epoxy resin composition set forth in any one of (1) to (4), further comprising (D) an antioxidant.
(6) A cyanate-epoxy resin composition set forth in (5) above, wherein the antioxidant (D) is contained in an amount of 0.1 to 20 parts by weight per 100 parts by weight of the cyanate type compound containing two or more cyanato groups in one molecule.
(7) A prepreg obtained by impregnating a base with a cyanate-epoxy resin composition set forth in any one of (1) to (6) above, and drying the same.
(8) A metal foil-laminated plate obtained by laminating a metal foil on one side or both sides of the prepreg set forth in (7) above or a laminate thereof, and hot-press molding the same.
(9) A printed wiring board obtained by forming circuits on the metal foil of the metal foil-laminated plate set forth in (8) above.

As the cyanate type compound (A) containing two or more cyanato groups in one molecule thereof used in the cyanate-epoxy resin composition of the present invention, there can be cited as exemplification thereof the compounds represented by the following formula (2), the concrete examples thereof being 2,2-bis(4-cyanatephenyl)propane, bis(3,5-dimethyl-4-cyanatephenyl)methane, 2,2-bis(4-cyanatephenyl) 1,1,1,3,3,3-hexafluoropropane and α,α'-bis(4-cyanatephenyl)-m-diisopropylbenzene. 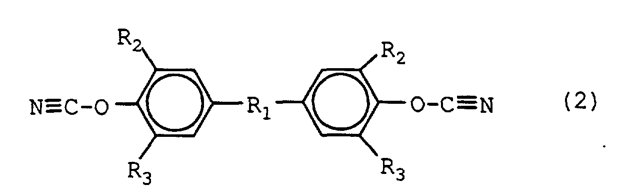 wherein R₁ is an alkylene group with a carbon number of 1 to 3 which may be substituted with a halogen, a group represented by the formula: 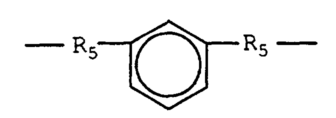 (wherein each R₅ is an alkylene group with a carbon number of 11 to 3, and the two R₅ may be identical or different), or a group represented by the formula: 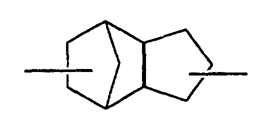 R₂ and R₃ represent respectively a hydrogen atom or an alkyl group with a carbon number of 1 to 4, and they may be-identical or different; the two R₂ may be identical or different, and the two R₃ may also be identical or different).

As the preferred examples of the above R₁, 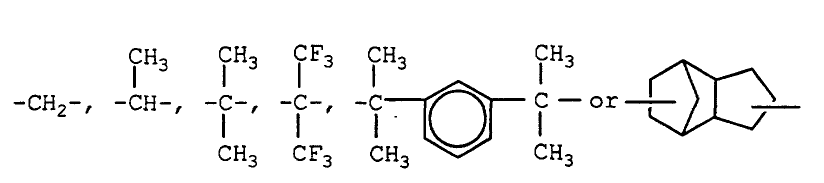 can be cited.

The monomers of the cyanate type compounds (A) having two or more cyanato groups in one molecule used in the present invention have high crystallinity, so that in case these monomers are made into a varnish with a solvent, they may be recrystallized in the varnish although this depends on the solids concentration. It is therefore preferable that these cyanate compound monomers be initially made into a prepolymer.

Such prepolymers can be obtained in quantity by reacting the monomers of the cyanate type compounds having two or more cyanato groups in one molecule, if necessary in the presence of an organic metal salt or an organic metal complex having a catalytic function to accelerate the reaction of the cyanate type compound, especially by subjecting the cyanato groups to a cyclization reaction (triazine cyclization). The reaction is preferably carried out so that the conversion of the monomers of the cyanate type compounds will become 10 to 70 mol%, especially 30 to 60 mol%. If the conversion is too low, the cyanate compound may be recrystallized when made into a varnish because of strong crystallizability. On the other hand, if the conversion is too high, viscosity of the produced varnish increases to impede its impregnation into the glass base, which may make it unable to obtain smoothness of the prepreg surface. Also, the gelation time may be so shortened as to pose a problem in coating work, and preservation stability (pot life) of the varnish tends to deteriorate.

Further, the prepolymer obtained from the monomers of the cyanate type compound (A) having two or more cyanato groups in one molecule in the present invention is, in many cases, a monomer-containing composition whose number-average molecular weight, as a whole, is preferably 250 to 1,000, especially 300 to 800. The number-average molecular weight shown here was determined by gel permeation chromatography (GPC) using the calibration curves of standard polystyrene. If this molecular weight is too small, there may take place recrystallization of the cyanate compound when it is made into a varnish because of strong crystallizability of the compound, and if the molecular weight is too large, viscosity of the produced varnish elevates to hamper its impregnation into the glass base, which may make it unable to obtain smoothness of the prepreg surface, or the gelation time may be so shortened as to pose a problem in coating work, and preservation stability (pot life) of the varnish tends to deteriorate, as in the case of the conversion described above.

As such prepolymers, those commercially available as, for instance, Arocy B-30 and Arocy M-30 (both being the trade names of the products by Asahi Ciba, Ltd.) can be used.

The epoxy resin (B) used in the present invention comprises as its essential component an epoxy resin derived from a dicyclopentadiene-phenol polyaddition product having a dicyclopentadiene sekeleton represented by the formula (1), and may contain other epoxy compound having two or more epoxy groups in one molecule. The epoxy resin of the formula (1) is preferably used in an amount of 15 to 100% by weight, more preferably 30 to 100% by weight of the overall amount of the epoxy resin (B). If the amount of the epoxy resin of the formula (1) is less than 15% by weight, a reduction of Tg (glass transition temperature) of the cured product and a rise of its susceptibility to water tend to take place. In case of using a halogenated (especially brominated) epoxy resin for making the composition flame retardant, the quantity from which at least the amount of this halogenated epoxy resin used has been deducted should be made the upper limit of the amount of the epoxy resin of the formula (1) to be used. The halogen content is preferably 10 to 25% by weight based on the resin solids content.

The dicyclopentadiene-phenol polyaddition product having a dicyclopentadiene skeleton represented by the formula (1) is preferably the one of the formula (1) in which n is a number of 5 or less.

As the epoxy resin used in combination (with the epoxy resin of the formula (1)), bisphenol A type epoxy resins, phenol novolak epoxy resins, cresol type epoxy resins, biphenyl type epoxy resins, phenol-salicylaldehyde novolak epoxy resins and the like can be cited.

Further, as the halogenated epoxy resin used for securing flame retardancy of the produced printed wiring board, brominated epoxy resins such as brominated bisphenol A type epoxy resins and brominated phenol novolak epoxy resins can be cited. Brominated bisphenol A type epoxy resins are preferred in view of their dielectric characteristics.

The amount of the epoxy resin (B) used in the cyanate-epoxy resin composition of the present invention is preferably 50 to 250 parts by weight per 100 parts by weight of the cyanate type compound (A) containing two or more cyanato groups in one molecule. If the amount of the epoxy resin (B) is less than 50 parts by weight, the composition shows a tendency to deteriorate in heat resistance when moisture is absorbed, and if the amount of (B) exceeds 250 parts by weight, there arises a tendency for the dielectric characteristics to deteriorate and for the glass transition temperature (Tg) to lower. The more preferred amount range of the epoxy resin (B) is 100 to 230 parts by weight.

The curing accelerator (C) used in the present invention comprises (i) a compound having a catalytic function to accelerate the curing reaction of the cyanate type compound (A) containing two or more cyanato groups in one molecule and (ii) a compound having a catalytic function to accelerate the curing reaction of the epoxy resin (B).

As the compound having a catalytic function to accelerate the curing reaction of the cyanate type compound (A) containing two or more cyanato groups in one molecule, organic metal salts or organic metal complexes can be used.

As the metal of the organic metal salts or organic metal complexes, iron, copper, zinc, cobalt, nickel, manganese, tin, etc., can be used.

As the organic metal salts, there can be cited iron naphthenate, copper naphthenate, zinc naphthenate, cobalt naphthenate, nickel naphthenate, manganese naphthenate, tin naphthenate, zinc octynoate, tin octynoate, zinc 2-ethylhexanate and the like. As the organic metal complexes, dibutyltin maleate and leadacetyl acetonate can be cited.

Such an organic metal salt or complex is preferably blended in an amount of 0.05 to 3 parts by weight per 100 parts by weight of the cyanate type compound (A) containing two or more cyanato groups in one molecule. If the amount of this compound is less than 0.05 part by weight, its catalytic function declines, necessitating a longer time for curing. If its amount exceeds 3 parts by weight, storage stability of the produced vanish or prepreg tends to deteriorate. The more preferred amount range of this compound is 0.1 to 1.0 part by weight.

As the compound having a catalytic function to accelerate the curing reaction of the epoxy resin (B), imidazole type compounds, organic phosphorus compounds, secondary amines, tertiary amines, quaternary ammonium salts and the like can be cited. Of these compounds, imidazole and its derivatives are the most preferred.

As imidazole and its derivatives used as the imidazole type compound in the present invention, the following can be cited: imidazole, 2-ethylimidazole, 2-ethyl-4-methylimidazole, 2-phenylimidazole, 2-undecylimidazole, 1-benzyl-2-methylimidazole, 2-heptadecylimidazole, 4,5-diphenylimidazole, 2-methylimidazoline, 2-phenylimidazoline, 2-undecylimidazoline, 2-heptadecylimidazoline, 2-isopropylimidazole, 2,4-dimethylimidazole, 2-phenyl-4-methylimidazole, 2-ethylimidazoline, 2-isopropylimidazoline, 2,4-dimethylimidazoline, and 2-phenyl-4-methylimidazoline. As the masking agent, acrylonitrile, phenylene diisocyanate, toluidine isocyanate, naphthalene diisocyanate, methylenebisphenyl isocyanate, melamine acrylate and the like can be used.

As the organic phosphorus compound, triphenylphosphine, etc., can be used. As the secondary amine, piperidine, etc., can be used; as the tertiary amine, dimethylbenzylamine, tris(dimethylaminomethyl)phenol, etc., can be used; and as the quaternary ammonium salt, tetrabutylammonium bromide, tetrabutylammonium chloride, etc., can be used.

The compound having a catalytic function to accelerate the curing reaction of the epoxy resin is preferably blended in an amount of 0.05 to 3 parts by weight per 100 parts by weight of the epoxy resin. If its amount is less than 0.05 part by weight, its catalytic function is poor and a longer time is required for curing. If its amount exceeds 3 parts by weight, storage stability of the produced varnish or prepreg deteriorates.

In the present invention, the total amount of the curing accelerator is preferably set to be 0.1 to 5 parts by weight per 100 parts by weight of the cyanate type compound (A) containing two or more cyanato groups in one molecule. If its amount is less than 0.1 part by weight, its catalytic function declines and the curing time tends to elongate. If its amount exceeds 5 parts by weight, storage stability of the produced varnish or prepreg tends to deteriorate.

As the antioxidant (D) used in the cyanate-epoxy resin composition of the present invention, phenolic antioxidants, organic sulfur compound type antioxidants, etc., can be cited.

Examples of the phenolic antioxidants include monophenolic type such as pyrogallol, butylated hydroxyanisole and 2,6-di-t-butyl-4-methylphenol, bisphenolic type such as 2,2'-methylene-bis-(4-methyl-6-t-butylphenol) and 4,4'-thiobis-(3-methyl-6-t-butylphenol), and high-molecular phenolic type such as 1,3,5-trimethyl-2,4,6-tris(3,5-di-t-butyl-4-hydroxybenzyl)benzene and tetrakis-[methylene-3-(3'-5'-di-t-butyl-4'-hydroxyphenyl)propionate]methane. Of these phenolic antioxidants, bisphenolic antioxidants are especially preferred in respect of effect.

Examples of the organic sulfur compound type antioxidants are dilauryl thiodipropionate and distearyl thiodipropionate.

These antioxidants may be used singly or different types thereof may be used together.

The antioxidant (D) of the present invention is preferably used in an amount of 0.1 to 20 parts by weight, more preferably 1 to 10 parts by weight, per 100 parts by weight of the cyanate type compound containing two or more cyanato groups in one molecule. If the amount of the antioxidant (D) is less than 0.1 part by weight, no improvement of insulating characteristics is seen, and if its amount exceeds 20 parts by weight, there is rather noted a tendency for the insulating characteristics to deteriorate.

In the cyanate-epoxy resin composition of the present invention, filler and other additives may be blended as desired.

Ordinary inorganic fillers can be favorably used as filler in the present invention. To be specific, molten silica, glass, alumina, zircon, calcium silicate, calcium carbonate, silicon nitride, boron nitride, beryllia, zirconia, calcium titanate, aluminum silicate, magnesium silicate and the like can be used in the form of powder or sphered beads. It is also possible to blend whisker, single-crystal fiber, glass fiber, and inorganic and organic hollow fillers. Such a filler is preferably blended in an amount of 5 to 30 parts by weight per 100 parts by weight of the resin solids. If the filler amount is less than 5 parts by weight, there cannot be obtained the effect of filler blending, and if its amount exceeds 30 parts by weight, sedimentation or aggregation of the filler tends to take place.

The cyanate-epoxy resin composition of the present invention is cured by heating and offered to the manufacture of prepregs, laminates, metal foil-laminated plates and printed wiring boards having excellent dielectric characteristics and heat resistance and low susceptibility to water.

For this, it is desirable that the cyanate-epoxy resin composition of the present invention be once dissolved in a solvent to form a varnish

The solvent is not specifically limited, but ketone type, aromatic hydrocarbon type, ester type, amide type, alcohol type, etc., are used. To be concrete, the ketone type solvents include acetone, methyl ethyl ketone, methyl isobutyl ketone and cyclohexane, the aromatic hydrocarbon type solvents include toluene and xylene, the ester type solvents include methoxyethyl acetate, ethoxyethyl acetate, butoxyethyl acetate and ethyl acetate, the amide type solvents include N-methylpyrrolidone, formamide, N-methylformamide and N,N-dimethylacetamide, and the alcohol type solvents include methanol, ethanol, ethylene glycol, ethylene glycol monomethyl ether, ethylene glycol monoethyl ether, diethylene glycol, triethylene glycol monomethyl ether, triethylene glycol monoethyl ether, triethylene glycol, propylene glycol monomethyl ether, dipropylene glycol monomethyl ether, propylene glycol monopropyl ether, and dipropylene glycol monopropyl ether. These solvents may be used either singly or by mixing two or more of them.

As the base for the prepreg, an ordinarily used base, for example, a 30 to 200 µm glass cloth is preferably used.

The manufacture of the prepreg is carried out by using a B-stage material prepared by impregnating a glass cloth with a varnish and drying it at 140 to 200°C for 3 to 15 minutes. Impregnation is preferably conducted so that the varnish solids content will become 35 to 60% by weight based on the total amount of the varnish solids and the base.

Using a single sheet of prepreg or any desired number of sheets of prepreg laminated, a metal foil is placed on one side or both sides thereof and subjected to hot-press molding to make a metal foil-laminated plate. As for the conditions of this operation, preferably the heating temperature is 150 to 230°C and the pressure applied is 2 to 5 MPa, and the laminate is kept under this condition for 0.5 to 2.0 hours.

As said metal foil, an ordinarily used copper foil, aluminum foil or the like is employed. The metal foil thickness, although variable depending on the purpose of use, is preferably 10 to 100 µm.

Circuits are formed on the metal foil of the metal foil-laminated plate by a conventional method to make a printed wiring board. Circuit formation can be accomplished, for example, by a method comprising the steps of forming a resist pattern on the metal foil surface, etching away the unnecessary portion of the foil, stripping off the resist pattern, drilling the necessary through-holes, again forming the resist pattern, plating the through-holes for making them conductive, and finally stripping off the resist pattern. On the surface of the thus obtained printed wiring board, the said metal foil-laminated plate is further laminated under the same conditions as described above, and circuits are formed thereon in the same way as described above to make a multi-layer printed wiring board. In this case, it is not always necessary to form through-holes; it is possible to form via holes instead or to form both of them. The number of the layers to be formed is optional.

The ordinary epoxy resin curing reactions are subject to a limitation over the attainable degree of reduction of dielectric constant because a hydroxyl group with high polarity is generated with ring-opening of the epoxy group. Also, in case of using a specific curing agent, typically a hydrocarbon-based polymer such as phenol-added polybutadiene, there arise problems such as impairment of inherent heat resistance of epoxy resins, lower glass transition temperature than when using a polyfunctional phenol resin for curing, and high cost. On the other hand, the cured products of cyanate ester resins having a low-polarity, rigid and symmetrical structure have the problems in adhesion, heat resistance in a moisture-absorbed state, etc., although they have a low dielectric constant, a low dielectric dissipation factor and a high glass transition temperature. The resin compositions using a conventional bisphenol A or brominated bisphenol A based epoxy resin in combination with a cyanate ester resin for improving the above problems involve their own problems such as increased susceptibility to water and poor adhesion to metals.

The cyanate-epoxy resin composition of the present invention, as compared with the conventional epoxy resin-based resin compositions for printed wiring boards or the said resin composition comprising a combination of a cyanate ester resin and an epoxy resin, is higher in glass transition temperature, excels in dielectric characteristics, heat resistance and susceptibility to water, and is capable of providing the laminated plates and printed wiring boards having the said properties. In the present invention, these effects are realized by combining a cyanate compound of this invention and a specific epoxy resin, and further using therewith the curing accelerators suited for them respectively.

Further, by use of an antioxidant, galvanic corrosion resistance can be improved without compromising the above-said characteristics.

In the following, the present invention is explained by showing the embodiments thereof, but the present invention is not limited to these embodiments.

### Example 1

A 2,2-bis(4-cyanatephenyl)propane prepolymer (Arocy B-30, trade name, produced by Asahi Ciba, Ltd.; monomer reaction rate: about 46%; number-average molecular weight: 560; cyanate equivalent: 200) was used as the cyanate type compound (A) containing two or more cyanato groups in one molecule, and a dicyclopentanediene type epoxy resin (HP7200H, trade name, produced by Dainippon Ink and Chemicals, Inc.; epoxy equivalent: 287) and a brominated bisphenol A type epoxy resin (ESB400T, trade name, produced by Sumitomo Chemical Co., Ltd.) were used as the expoxy resin (B). These materials were dissolved in methyl ethyl ketone in the ratios shown in Table 1, and then cobalt naphthenate and 2-methylimidazole (2MZ) were blended as the curing accelerator (C) in the ratios shown in Table 1 to prepare a cyanate-epoxy resin composition varnish with a nonvolatile content of 70% by weight.

### Example 2

A cyanate-epoxy resin composition varnish was prepared in the same way as in Example 1 except that a bis(3,5-dimethyl-4-cyanatephenyl)methane prepolymer (Arocy M-30, trade name, produced by Asahi Ciba Ltd.; monomer reaction rate: about 46%; number-average molecular weight: 490; cyanate equivalent: 219) was used as the cyanate type compound (A) containing two or more cyanato groups in one molecule in place of the 2,2-bis(4-cyanatephenyl)propopane prepolymer, and it was dissolved in methyl ethyl ketone in the ratio shown in Table 1, and that zinc naphthenate was used in place of cobalt naphthenate and 2-ethyl-4-methylimidazole was used in place of 2-methylimidazole, they being blended in the ratios shown in Table 1.

### Example 3

A cyanate-epoxy resin composition varnish was prepared in the same way as in Example 1 except that manganese naphthenate was used in place of cobalt naphthenate and 2-undecylimidazole (C11Z, trade name, produced by Shikoku Chemicals Corp.) was used in place of 2-methylimidazole (2MZ) as the curing accelerator (C), and they were blended in the ratios shown in Table 1.

### Example 4

A cyanate-epoxy resin composition varnish was prepared in the same way as in Example 1 except that zinc naphthenae was used in place of cobalt naphthenate and 2-undecylimidazole (C11Z, trade name, produced by Shikoku Chemicals Corp.) was used in place of 2-methylimidazole (2MZ) and blended in the ratios shown in Table 1.

### Comparative Example 1

A cyanate-epoxy resin composition varnish was prepared in the same way as in Example 1 except that a bisphenol A type epoxy resin (DER331L, trade name, produced by Dow Chemical Japan, Ltd.; epoxy equivalent: 185) was used in place of the dicyclopentadiene type epoxy resin.

### Comparative Example 2

A cyanate-epoxy resin composition varnish was prepared in the same way as in Example 1 except that a bisphenol A type epoxy resin (DER331L, trade name, produced by Dow Chemical Japan Ltd.; epoxy equivalent: 185) alone was used as the epoxy resin and dissolved in methyl ethyl ketone in the ratio shown in Table 1.

### Comparative Example 3

A cyanate resin composition varnish was prepared without blending any epoxy resin in the formulation of Example 1 and otherwise according to the description in Table 1.

### Comparative Example 4

A brominated bisphenol A type epoxy resin (ESB400T, trade name, produced by Sumitomo Chemical Co., Ltd.; epoxy equivalent: 401) was used as the epoxy resin and a phenol novolak resin (HP850N, trade name, produced by Hitachi Chemical Company, Ltd.; hydroxy equivalent: 106) was used as the curing agent. They were blended in an equivalent ratio of 1 : 1 and dissolved in methyl ethyl ketone, and then 2-methylimidazole was blended in the ratio shown in Table 1 to prepare an epoxy resin composition varnish with a nonvolatile content of 70% by weight.

### Comparative Example 5

A cyanate-epoxy resin composition varnish was prepared according to Example 4 except that the curing accelerator 2-undecylimidazole was not used.

Each of the varnishes of Examples 1 to 4 and Comparative Examples 1 to 5 was impregnated in a 0.2 mm thick glass cloth (basis weight: 210 g/m²) and dried at 160°C for 5 minutes to obtain a prepreg. 4 sheets of this prepreg and the 18 µm thick copper foils were laminated, with the copper foils being placed at the top and bottom of the laminate, and press molded under the conditions of 170°C and 2.45 MPa for one hour to produce a copper-clad laminate. Then, after forming an etching resist, circuits were formed by etching to obtain a printed wiring board. The process from the formation of etching resist to the start of etching was conducted in the conventional way. Glass transition temperature (Tg), dielectric constant, solder heat resistance, water absorption and flame retardancy of this printed wiring board were evaluated.

The evaluation methods were as described below.
Glass transition temperature (Tg):
Determined by the thermomechanical analytical method (TMA method).
Dielectric characteristics:
Evaluated by a Noyman's Wide-Band Dielectric Characteristics Tester (gap varying method).
Solder heat resistance:
Each test piece cut to a 50 mm × 50 mm size was subjected to a 3-hour moisture absorbing treatment under the conditions of 121°C and 0.22 MPa in a pressure cooker and then immersed in a 260°C solder bath for 20 seconds, and the condition of the test piece was visually observed. The evaluation result was marked with ○ when the test piece had no blister and measling, Δ when the test piece had measling, and x when the test piece had blister.
Water absorption:
Each 50 mm × 50 mm test piece was subjected to a 3-hour moisture absorbing treatment under the conditions of 121°C and 0.22 MPa, and water absorption was calculated from the difference in weight between before and after the moisture absorbing treatment.
Flame retardancy:
Evaluated according to the UL94 vertical testing method.

The determination and evaluation results are shown in Table 1.

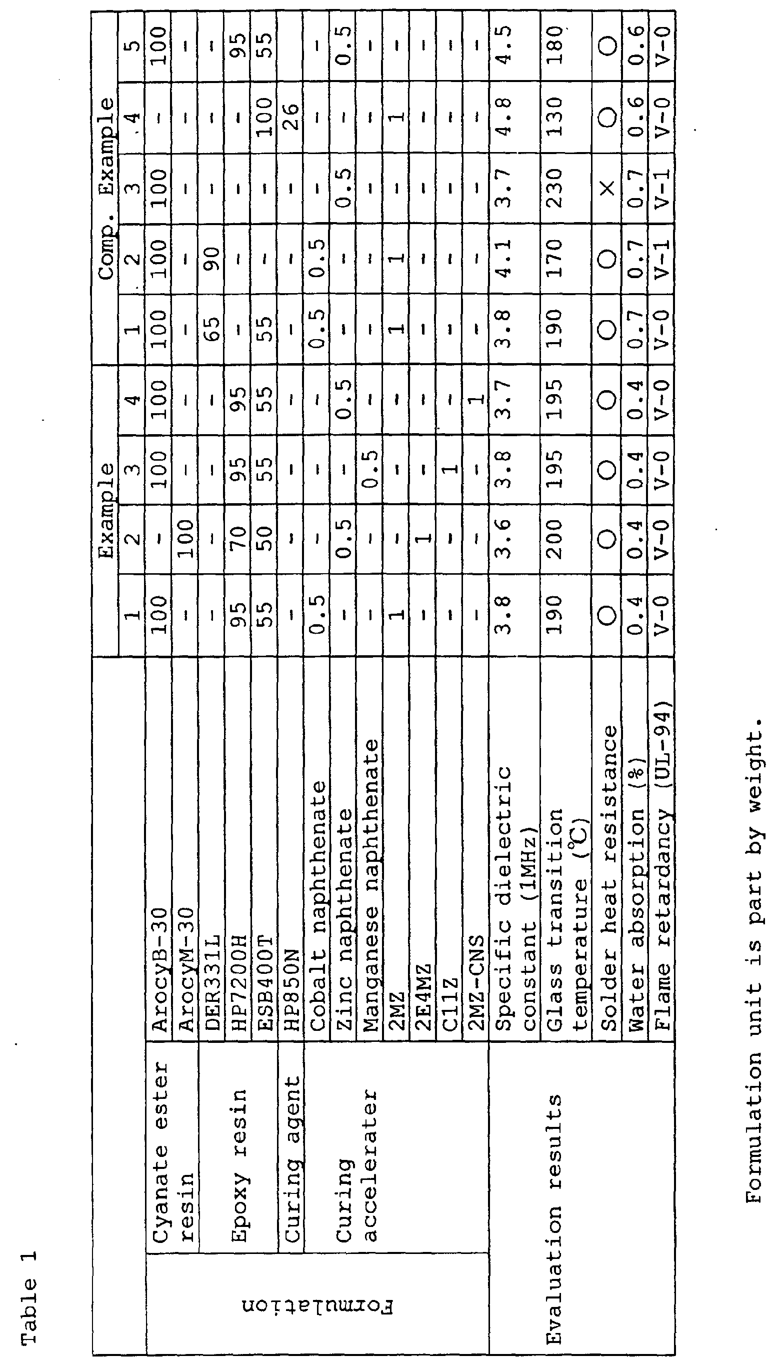

As is seen from Table 1, Comparative Example 1, in which a bisphenol A type epoxy resin (DER221L) and a brominated bisphenol A type epoxy resin (ESB400T) were blended as the epoxy resin, is inferior in specific dielectric constant, glass transition temperature (Tg) and susceptibility to water in comparison with the examples where an epoxy resin (HP7200H) derived from a dicyclopentadiene-phenol polyaddition product having a dicyclopentadiene skeleton and a brominated bisphenol A type epoxy resin (ESB400T) were blended. Comparative Example 2, in which a bisphenol A type epoxy resin alone was used as the epoxy resin, is inferior in specific dielectric constant, glass transition temperature (Tg), susceptibility to water and flame retardancy in comparison with the examples where an epoxy resin derived from a dicyclopentadiene-phenol polyaddition product having a dicyclopentadiene skeleton was used in combination with a brominated bisphenol A type epoxy resin. Comparative Example 3, where no epoxy resin was blended, is poor in solder heat resistance, susceptibility to water and flame retardancy. Comparative Example 4, which is a laminated plate using no cyanate ester resin, is high in specific dielectric constant and low in glass transition temperature (Tg). In contrast with these comparative examples, the cyanate-epoxy resin composition of the present invention excels in glass transition temperature (Tg), dielectric constant and heat resistance, and also has low susceptibility to water.

### Examples 5 to 8 and Comparative Examples 6 to 10

Varnishes were prepared following the procedure of Example 1 according to the formulation shown in Table 2, and then determinations were made as in Example 1. Test results are shown in Table 2.

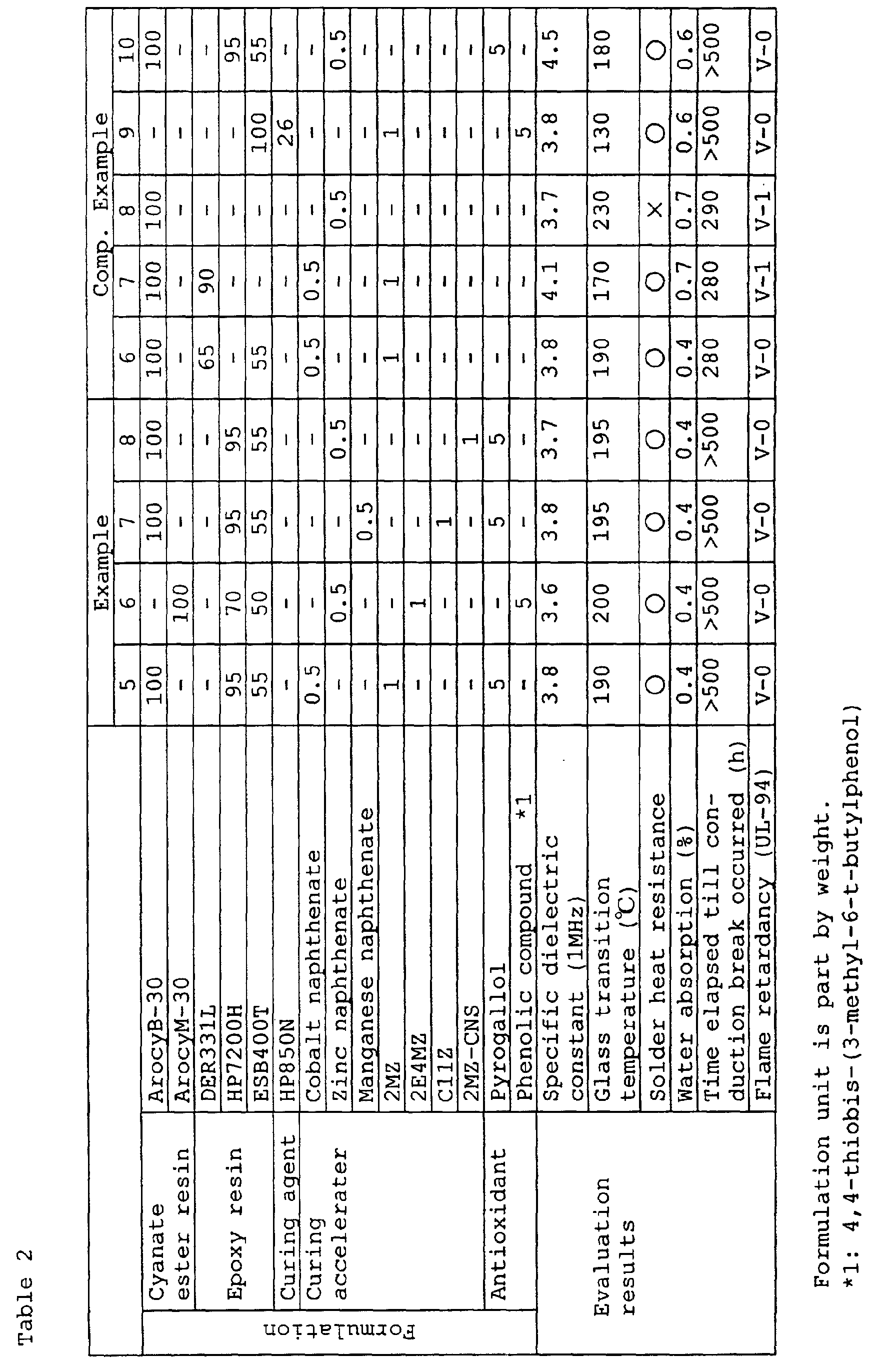

As is apparent from Table 2, the Examples according to the present invention are excellent in glass transition temperature (Tg), specific dielectric constant, heat resistance, susceptibility to water and galvanic corrosion resistance.

### INDUSTRIAL APPLICABILITY

The cyanate-epoxy resin composition of the present invention excels in glass transition temperature (Tg), dielectric characteristics and heat resistance and also has low susceptibility to water. The prepregs obtained by using this composition and the laminates, metal foil-laminated plates and printed wiring boards using such prepregs are possessed of the specific properties such as heat resistance, dielectric characteristics and low hygroscopicity required in application to computers. Further, by adding an antioxidant to this cyanate-epoxy resin composition, galvanic corrosion resistance is improved without affecting the above properties.

## Claims

1. A cyanate-epoxy resin composition comprising (A) a cyanate type compound containing two or more cyanto groups in one molecule thereof, (B) an epoxy resin, and (C) a curing accelerator as main components, wherein the epoxy resin is derived from a dicyclopentadiene-phenol polyaddition product having a dicyclopentadiene skeleton represented by the following formula (1), and the curing accelerator comprises (i) a compound having a catalytic function to accelerate the curing reaction of the cyanate type compound containing two or more cyanato groups in one molecule and (ii) a compound having a catalytic function to accelerate the curing reaction of the epoxy resin: 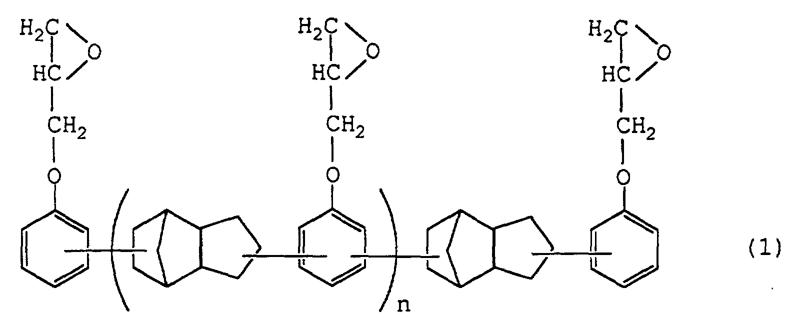 (wherein n is 0 or a positive integer).

2. A cyanate-epoxy resin composition according to Claim 1, wherein the compound having a catalytic function to accelerate the curing reaction of the cyanate type compound containing two or more cyanato groups in one molecule is an organic metal salt or an organic metal complex, and the compound having a catalytic function to accelerate the curing reaction of the epoxy resin is an imidazole compound.

3. A cyanate-epoxy resin composition according to Claim 2, wherein the organic metal salt or the organic metal complex is an organic metal salt or an organic metal complex of iron, copper, zinc, cobalt, nickel, manganese or tin.

4. A cyanate-epoxy resin composition according to any one of Claims 1 to 3, wherein the epoxy resin (B) is contained in an amount of 50 to 250 parts by weight and the curing accelerator (C) in an amount of 0.1 to 5 parts by weight per 100 parts by weight of the cyanate type compound (A) containing two or more cyanato groups in one molecule.

5. A cyanate-epoxy resin composition according to any one of Claims 1 to 4, which further comprises an antioxidant (D).

6. A cyanate-epoxy resin composition according to Claim 5, wherein the antioxidant (D) is contained in an amount of 0.1 to 20 parts by weight per 100 parts by weight of the cyanate type compound (A) containing two or more cyanato groups in one molecule.

7. A prepreg obtained by impregnating a cyanate-epoxy resin composition described in any one of Claims 1 to 6 in a base, and drying the same.

8. A metal foil-laminated plate obtained by laminating a metal foil on one side or both sides of the prepreg described in Claim 7 or a laminate thereof, and subjecting the laminate to hot-press molding.

9. A printed wiring board obtained by conducting a circuit-forming work on the metal foil of the metal foil-laminated plate described in Claim 8.

10. A cyanate-epoxy resin composition according to any one of Claims 1 to 6, wherein the compound having a catalytic function to accelerate the curing reaction of the cyanate type compound (A) is at least one of the organic metal salts or organic metal complexes of one or more of the metals selected from iron, copper, zinc, cobalt, nickel, manganese and tin, and the compound having a catalytic function to accelerate the curing reaction of the epoxy resin (B) is at least one compound selected from imidazole and its derivatives, organic phosphorus compounds, secondary amines, tertiary amines and quaternary ammonium salts.
